# EUROPÄISCHE PATENTSCHRIFT

(11) **EP 0 688 083 B1**
(45) Veröffentlichungstag und Bekanntmachung des Hinweises auf die Patenterteilung: **19.12.2001**
(21) Anmeldenummer: 95810367.3
(22) Anmeldetag: 06.06.1995
(51) Int. Cl.: H02J 7/00, E03C 1/05

(54) **Verfahren und Anordnung zur berührungslosen elektronischen Steuerung des Wasserflusses einer Sanitäranlage**
Method and apparatus for non-contact electronic control of waterflow in a sanitary installation
Appareil et procédé de commande sans contact du débit d'eau dans une installation sanitaire

(30) Priorität: 13.06.1994 CH 185994
(43) Veröffentlichungstag der Anmeldung: 20.12.1995
(73) Patentinhaber: GEBERIT TECHNIK AG, 8645 Jona (CH)
(72) Erfinder: Mauerhofer, Alex, CH-7324 Vilters (CH)
(74) Vertreter: Groner, Manfred

(56) Entgegenhaltungen:
- EP-A- 0 313 162
- EP-A- 0 423 102
- EP-A- 0 433 631
- EP-A- 0 438 141
- EP-A- 0 600 234
- US-A- 4 521 735
- US-A- 4 908 523
- US-A- 5 217 035

## Beschreibung

Die Erfindung betrifft ein Verfahren nach dem Oberbegriff des Anspruchs 1.

Verfahren zur berührungslosen, elektronischen Steuerung des Wasserflusses von Waschanlagen sind beispielsweise aus der CH-A-651 143, der CH-A-646 766 und der DE-A 39 20 581 bekannt. Werden die hier offenbarten Anordnungen mit einer Batterie betrieben, so müssen diese bei Erreichen einer bestimmten Restkapazität rechtzeitig ausgewechselt werden. Um einen fälligen Batteriewechsel anzuzeigen, wurde bisher geprüft, ob die Spannung der Batterie einen vorbestimmten Spannungswert überschreitet. Eine ungenügende Spannung wurde mittels einer LED angezeigt.

Die gattungsbildende EP-0 313 162 A offenbart eine Anordnung zur Steuerung einer Spülung, bei welcher nach Empfang eines vom Benutzer reflektierten Detektionsimpulses die Steuerschaltung eine Testeinheit über den gemessenen Ladungszustand abfragt. Das Ventil der Wasserspülung wird nur dann geöffnet, wenn der Ladungszustand der Batterie ausreicht, um das Ventil nach der Einschaltung wieder abzustellen.

Der Erfindung liegt die Aufgabe zugrunde, ein Verfahren der genannten Art zu schaffen, die eine höhere Funktionssicherheit gewährleisten. Die Aufgabe ist durch die Erfindung gemäss Anspruch 1 gelöst.

Durch die Erfindung kann insbesondere verhindert werden, dass bei ungenügender Batteriespannung das Wasserventil angesteuert und geöffnet, aber nicht mehr geschlossen werden kann. Ebenfalls lässt sich vermeiden, dass der Mikroprozessor in einen unkontrollierten Zustand geraten kann.

Ein weiterer Vorteil wird darin gesehen, dass die Batteriekapazität bis zu einer garantierten minimalen Ventil-Schliesspannung genutzt werden kann. Die Nutzdauer einer Batterie wird somit verlängert, ohne dass vermehrt Fehlfunktionen zu erwarten sind.

Weitere Vorteile ergeben sich aus den abhängigen Patentansprüchen und der nachfolgenden Beschreibung.

Die berührungslose, elektronische Steuerung ist beispielsweise an einem Wasserauslauf eines Waschbeckens angeordnet. Zur Steuerung des Wasserventils dient beispielsweise ein bekannter Infrarotlichttaster. Beim Einführen beispielsweise einer Hand in den Abtastbereich des Infrarotlichttasters spricht dieser an und gibt ein Signal ab, das verstärkt wird und veranlasst, dass das Wasserventil geöffnet oder geschlossen wird. Zur Steuerung ist ein Mikroprozessor und zur Spannungsversorgung eine Batterie vorgesehen. Ebenfalls ist eine von aussen sichtbare Anzeige, beispielsweise eine an sich bekannte LED vorgesehen, welche den Zustand der Batterie anzeigt.

Das verwendete Wasserventil ist vorzugsweise ein Servo-Impulsventil, bei dem für das sichere Oeffnen und Schliessen bestimmte Minimalgrenzwerte der Batteriespannung angegeben werden können. Zu beachten ist, dass diese Grenzwerte infolge des unvermeidlichen Batterie-Innenwiderstandes im belasteten Zustand der Batterie, also am Ende des Steuerimpulses vorhanden und gemessen werden müssen. Die minimale Schliesspannung sollte kleiner sein als die minimale Oeffnungsspannung, so dass es immer möglich ist, nach dem Oeffnen des Ventils dieses mit derselben Batteriespannung auch wieder schliessen zu können.

Um den Zustand der Batterie bzw. ihre Fähigkeit zum sicheren Oeffnen und Schliessen des Ventils und zum sicheren Betreiben des Mikroprozessors beurteilen zu können, werden im Mikroprozessor drei Referenzspannungen gebildet.

Die erste Referenz **U(1)** entspricht einer Batteriespannung, welche mit Bezug auf die garantierte minimale Oeffnungs-Spannung des Ventils einer Kapazitätsreserve von noch ca. 10% entspricht. Die zweite Referenz **U(0)** entspricht der garantierten minimalen Schliess-Spannung des Ventils. Die dritte Referenz **U(P)** entspricht der minimalen Batteriespannung, bei welcher der Mikroprozessor noch arbeiten kann. U(P) ist kleiner als U(0) und U(0) ist wiederum kleiner als U(1).

Die verbleibende Kapazität einer Lithiumbatterie 2CR5 lässt sich annähernd aus ihrer Entladekennlinie, dem absinkenden Verlauf der Batteriespannung über der Entladezeit, entnehmen. Dies bedeutet, dass z.B. einer Restkapazität von 10% bzw. der vollständigen Entladung eine bestimmte Rest-Batteriespannung zugeordnet werden kann.

Durch Vergleichen der aktuell vorhandenen Batteriespannung im unbelasteten bzw. durch das Ventil belasteten Zustand mit den erwähnten Referenzspannungen ordnet die Elektronik den aktuellen Batteriezustand einem der folgenden Zustände zu:

| | |
|---|---|
| Neue Batterie prüfen | Initialisierung |
| Batterie in Ordnung | Zustand BO |
| Batteriereserve 10%, belastet | Zustand B1 |
| Batteriereserve 10%, unbelastet | Zustand B2 |
| Batteriereserve 0%, belastet | Zustand B3 |
| Minimalspannung Mikroprozessor | Systemabschaltung B4 |

Die verschiedenen Zustände werden durch die Anzeige beispielsweise wie folgt angezeigt:

| | |
|---|---|
| Initialisierung | LED blinkt |
| B-Zustand 0 | LED dunkel |
| B-Zustand 1 | LED blinkt |
| B-Zustand 2 | LED blinkt |
| B-Zustand 3 | LED-Dauerlicht |
| Systemabschaltung | LED-Dauerlicht |

In der folgenden Funktionsbeschreibung wird beschrieben, unter welchen Umständen in die verschiedenen Zustände eingetreten wird bzw. wie sie wieder verlassen werden können.

Nach dem Einsetzen der Batterie wird geprüft, ob die unbelastete Batteriespannung grösser oder kleiner als U(1) ist.

Ist sie grösser, so wird die Initialisierung eingeleitet. Während der Initialisierung blinkt die Anzeige-LED.

Ist die unbelastete Batteriespannung kleiner als U(1), so wurde versucht, eine bereits verbrauchte Batterie einzusetzen. In diesem Fall wird die Einleitung der Initialisierung verweigert, d.h. die LED-Anzeige zeigt Dauerlicht (sofern die Batterie noch fähig ist, die Anzeige-LED zum Leuchten zu bringen).

### Zustand BO

Dieser Zustand bedeutet, dass die Batterie in Ordnung ist. Die Anzeige-LED bleibt dunkel.

In kurzen Zeitabständen, beispielsweise jede Sekunde, wird die unbelastete Batteriespannung gemessen. Wird dabei festgestellt, dass die Batteriespannung grösser als U(1) ist, so wird der Zustand BO, andernfalls B2 (unbelastet) gesetzt.

Bei jeder Ventilöffnung wird die belastete Batteriespannung gemessen (Messung der belasteten Batteriespannung am Ende des Einschaltimpulses!). Wird dabei festgestellt, dass die Batteriespannung grösser als U(1) ist, so wird der Zustand B0, andernfalls B1 (belastet) gesetzt.

### Zustand B1

Dieser Zustand bedeutet, dass die belastete Batteriespannung einer Batteriereserve von weniger als 10% mit Bezug auf die minimal erforderliche Ventil-Einschaltspannung entspricht. Die Batterie sollte nun innerhalb der nächsten 2 bis 3 Wochen ausgewechselt werden.

Dieser notwendig gewordene Batteriewechsel wird durch eine andauernd mit beispielsweise 1 Hz blinkenden Anzeige-LED angezeigt.

Bei jedem Einschalten des Ventils wird hier die belastete Batteriespannung gemessen und mit U(0) verglichen. Ergibt dieser Vergleich einen Wert kleiner als U(0) so wird in den Zustand B3 gewechselt.

Wird die Batterie innerhalb der erwähnten 2 bis 3 Wochen nicht gewechselt, so ist es möglich, dass das System noch längere Zeit im Zustand B1 verbleibt und weiter funktioniert. Es muss jedoch damit gerechnet werden, dass von einem bestimmten Zeitpunkt an das Ventil nicht mehr öffnet, obschon es von der Elektronik noch angesteuert wird!

Grund: Die für das betreffende Ventil gültige minimale Einschaltspannung kann unterschritten werden bevor die für alle Ventile garantierte minimale Schliesspannung U(0) erreicht wird.

Der Vorteil dieser Methode ist, dass die Batteriekapazität bis zur garantierten minimalen Ventil-Schliesspannung genutzt werden kann.

### Zustand B2

Bei einer längere Zeit unbenutzten Waschtisch-Elektronik könnte sich die Batterie so weit entladen haben, dass eine Ventilbetätigung nicht mehr gesichert ist. Um diesen Fall abzudecken, wird mindestens einmal pro Sekunde auch die unbelastete Batteriespannung gemessen. Wird dabei ein Wert kleiner als U(1) ermittelt, so wird in diesen Zustand B2 gewechselt.

Der Zustand B2 unterscheidet sich vom Zustand B1 nur dadurch, dass vor dem nächstfolgenden Einschalten des Ventils ein Schliessimpuls zum Ventil gesendet wird. Die bei diesem Schliessimpuls ermittelte, und mit U(1) und U(0) verglichene belastete Batteriespannung entscheidet darüber, ob das Ventil eingeschaltet und in den Zustand B0 oder B1 gewechselt werden darf, oder ob direkt in den Zustand B3 übergegangen werden muss.

### Zustand B3

Dieser Zustand bedeutet, dass die belastete Batteriespannung nicht mehr mit Sicherheit ausreicht, um das Ventil schliessen zu können. Das Einschalten des Ventils in diesem Zustand wird daher vom System verweigert und diese Verweigerung mit Dauerlicht der Anzeige-LED dem Benutzer sichtbar gemacht.

Trotzdem wird hier bei jeder "Benutzung" des Waschtisches mit einem Schliessimpuls am Ventil überprüft, ob die vorhandene belastete Batteriespannung für das Ausschalten des Ventils eventuell nicht doch ausreichend ist. Damit wird die ansonst durch eine allfällige Fehlmessung herbeigeführte Systemblockierung zuverlässig vermieden.

### Zustand B4

Das korrekte Funktionieren des Mikroprozessors wird vom Hersteller nur oberhalb einer minimalen Betriebsspannung garantiert. Wird dieser Hinweis missachtet, so können vom Mikroprozessor irgendwelche erratischen Ausgansgsignale (z.B. ein Ventil-Einschaltbefehl!) abgegeben werden. Um dies zu vermeiden wird der Mikroprozessor unterhalb dieses Betriebsspannungsgrenzwertes U(P) abgeschaltet.

Die Anzeige-LED wird dabei von der Hardware des Elektronikmoduls weiterhin bis zur Batterieerschöpfung im Dauerlichtzustand gehalten.

## Patentansprüche

1. Verfahren zum berührungslosen, elektronischen Steuern des Wasserflusses einer Sanitäranlage, die einen Mikroprozessor und wenigstens ein Wasserventil sowie zur Spannungsversorgung eine Batterie aufweist, wobei die Batterie auf ihre Fähigkeit zum sicheren Schliessen des Wasserventils überprüft wird, **dadurch gekennzeichnet, dass** die Batterie laufend auf ihre Fähigkeit zum sicheren Öffnen und Schliessen des Wasserventils und zum Betreiben des Mikroprozessors überprüft wird.

2. Verfahren nach Anspruch 1, **dadurch gekennzeichnet, dass** zur Beurteilung der Fähigkeit der Batterie Referenzspannungen gebildet werden und diese mit der Batteriespannung im durch das Wasserventil belasteten oder unbelasteten Zustand der Batterie verglichen werden.

3. Verfahren nach Anspruch 2, **dadurch gekennzeichnet, dass** die drei folgenden Referenzspannungen gebildet werden:
a) eine erste Referenzspannung U(1), entsprechend der Batteriespannung, welche mit Bezug auf die minimale Öffnungs-Spannung des Ventils einer vorbestimmten Kapazitätsreserve von beispielsweise 10% entspricht,
b) eine zweite Referenzspannung U(0), welche der minimalen Schliess-Spannung des Ventils entspricht, und
c) eine dritte Referenzspannung U(P), welche der minimalen Batteriespannung, bei welcher der Mikroprozessor noch arbeiten kann, entspricht.

4. Verfahren nach Anspruch 2 oder 3, **dadurch gekennzeichnet, dass** die aktuell vorhandene Batteriespannung mit den Referenzspannungen verglichen wird und aufgrund dieses Vergleichs dem Batteriezustand einer der folgenden Zustände zugeordnet wird:
| | |
|---|---|
| Batterie in Ordnung | Zustand BO |
| Batteriereserve 10% bei belasteter Batterie | Zustand B1 |
| Batteriereserve 10% bei unbelasteter Batterie | Zustand B2 |
| Batteriereserve 0% bei durch das Wasserventil belasteter Batterie | Zustand B3 |
| Minimalspannung Mikroprozessor | Zustand B4 |

5. Verfahren nach Anspruch 4, **dadurch gekennzeichnet, dass** eine Anzeigevorrichtung, beispielsweise eine LED vorgesehen ist, welche die oben genannten Zustände 1 bis 4 anzeigt, beispielsweise mit Blinken oder Dauerlicht.

6. Verfahren nach einem der Ansprüche 1 bis 5, **dadurch gekennzeichnet, dass** die verbleibende Kapazität der Batterie aus ihrer Entladekennlinie, dem absinkenden Verlauf der Batteriespannung über der Entladezeit, entnommen wird und eine Restkapazität von beispielsweise 10% der vollständigen Entladung einer vorbestimmten Rest-Batteriespannung zugeordnet wird.

7. Verfahren nach einem der Ansprüche 1 bis 6, **dadurch gekennzeichnet, dass** nach dem Einsetzen der Batterie geprüft wird, ob die durch das wasserventil unbelastete Batteriespannung grösser oder kleiner ist als eine erste Referenzspannung U(1), und dass entsprechend die Initialisierung eingeleitet oder verweigert wird.

8. Verfahren nach einem der Ansprüche 3 bis 7, **dadurch gekennzeichnet, dass** in bestimmten, vergleichsweise kurzen Zeitabständen, beispielsweise jede Sekunde, die durch das Wasserventil unbelastete Batteriespannung gemessen wird und dass bei einer Batteriespannung grösser als U(1) der Zustand BO und andernfalls B2 gesetzt wird.

9. Verfahren nach Anspruch 8, **dadurch gekennzeichnet, dass** bei jeder Ventilöffnung die durch das wasserventil belastete Batteriespannung gemessen wird und dass bei einer Batteriespannung grösser als U(1) der Zustand BO und andernfalls B1 gesetzt wird.

10. Verfahren nach einem der Ansprüche 4 bis 9, **dadurch gekennzeichnet, dass** ein Batteriewechsel angezeigt wird, beispielsweise mittels einer blinkenden LED, wenn der Zustand B1 festgestellt wird und die durch das wasserventil belastete Batteriespannung mit Bezug auf die minimal erforderliche Ventil-Einschaltspannung einer Batteriereserve entspricht, die kleiner ist als eine vorbestimmte Batteriereserve, beispielsweise 10%.

11. Verfahren nach einem der Ansprüche 4 bis 10, **dadurch gekennzeichnet, dass** laufend in bestimmten Zeitabständen auch die durch das wasserventil unbelastete Batteriespannung gemessen wird und dass in den Zustand B2 gewechselt wird, wenn diese Batteriespannung kleiner als U(1) ist.

12. Verfahren nach einem der Ansprüche 4 bis 11, **dadurch gekennzeichnet, dass** beim Zustand B3 das Einschalten des Wasserventils verweigert wird, dass dieser Zustand beispielsweise mittels einer LED mit Dauerlicht angezeigt wird, und dass bei jedem neuen Schliessimpuls am Wasserventil überprüft wird, ob die vorhandene belastete Batteriespannung nicht doch für das Ausschalten des Wasserventils ausreicht.

13. Verfahren nach einem der Ansprüche 3 bis 12, **dadurch gekennzeichnet, dass** der Mikroprozessor bei einer Batteriespannung unterhalb U(P) abgeschaltet wird.

## Claims

1. A process for electronic control the fluid flow of a sanitary device, comprising a microprocessor, at least one water valve and a battery for the energy supply, wherein the battery is checked in respect of the ability to properly close said valve, **characterized in that**, the battery is continuously checked in respect of its ability to properly open and close the water valve and to operate said microprocessor.

2. A process in accordance with claim 1, wherein said energy requirements are in a form of reference voltages and wherein said reference voltages are compared with the battery voltage in a loaded and unloaded state respectively.

3. A process in accordance with claim 2, wherein the following three references voltages are generated:
a) a first reference voltage U(1) substantially equal to a minimum voltage required to open said valve plus a safety factor of e.g. 10 %,
b) second reference voltage U(O) substantially equal to a minimum voltage required to close said valve and
c) a third reference voltage U(P) substantially equal to a minimum voltage at which said microprocessor is still able to operate.

4. A process in accordance with claim 2 or 3, **characterized in** the current battery voltage being compared with the actual reference voltages, the electronic unit assigns the current state of the battery to one of the following states:
| | |
|---|---|
| Battery O.K. | State B0 |
| Battery reserve 10%, under load | State B1 |
| Battery reserve 10%, not loaded | State B2 |
| Battery reserve, wherein the battery is under load of the water valve | State B3 |
| Minimal voltage for microprocessor | Shut-off of system B4. |

5. A process in accordance with claim 4, **characterized in that** indicating means, e.g. a LED, is provided, indicating the above noted states, e.g. with one of flashing and continuous light.

6. A process in accordance with any of the claims 1 to 5, **characterized in that** determining a remaining capacity of said battery from a discharge curve of said battery, said discharge curve describing battery voltage as a function of discharge time, assigning a residual capacity, e.g. 10%, to a predetermined residual battery voltage.

7. A process in accordance with any of the claims 1 to 6, **characterized in that**, after inserting the battery, a check is made if the battery voltage, loaded from the water valve, is greater or less than a first reference voltage U(1) and that accordingly the initialization is accepted or rejected.

8. A process in accordance with any of the claims 3 to 7, **characterized in that**, measuring said unloaded voltage at periodic intervals, entering said B0 state if said unloaded voltage is greater than U(1) and entering said B2 state otherwise.

9. A process in accordance with claim 8, **characterized in that**, measuring said loaded voltage each time said valve is opened, entering said B0 state if said loaded voltage is greater than U(1) and entering said B1 state otherwise.

10. A process in accordance with any of the claims 4 to 9, **characterized in that**, a battery change is indicated by means of a flashing LED when state B1 is determined, and when a battery voltage under load from the water valve corresponds, with respect to the minimum voltage necessary for switching on the valve, to a battery reserve that is lower than a predetermined battery reserve, e.g. 10%.

11. A process in accordance with any of the claims 4 to 10, **characterized in that**, the battery voltage, unloaded from the water valve, is measured at periodic intervals and that a switch is made to state B2, if the battery voltage is below U(1).

12. A process in accordance with any of the claims 4 to 11, **characterized in that**, in said B3 state, blocking said control circuit means from opening said valve in response to said sensory input, generating a continuous light signal, e.g. with a LED, sending a closing pulse to said valve when said sensory input indicates to open said valve, measuring said loaded voltage during said closing pulse to determine whether said ability of said power supply is sufficient for closing said valve.

13. A process in accordance with any of the claims 3 to 12, **characterized in that**, de-energizing said microprocessor when said battery voltage is less than U(P).

## Revendications

1. Procédé pour la commande électronique, sans contact, de l'écoulement d'eau d'une installation sanitaire, qui comporte un microprocesseur et au moins une soupape d'amenée d'eau, ainsi que pour l'alimentation en tension d'une pile, dont la capacité à fermer de façon sûre la soupape d'amenée est contrôlée, **caractérisé en ce que** la capacité de la pile à ouvrir et à fermer de façon sûre la soupape d'amenée d'eau et à faire fonctionner le microprocesseur est contrôlée en permanence.

2. Procédé selon la revendication 1, **caractérisé en ce que** pour l'évaluation de la capacité de la pile, des tensions de référence sont formées et ces dernières sont comparées à la tension de la pile lorsque la pile est à l'état sollicité ou non sollicité par la soupape d'amenée d'eau.

3. Procédé selon la revendication 2, **caractérisé en ce que** les tensions de référence suivantes sont formées:
a) une première tension de référence U(1), correspondant à la tension de la pile et qui correspond, par rapport à la tension d'ouverture minimale de la soupape, à une réserve prédéterminée de capacité de par exemple 10 %,
b) une seconde tension de référence U(0) qui correspond à la tension de fermeture minimale de la soupape, et
c) une troisième tension de référence U(P), qui correspond à la tension minimale de la pile, à laquelle le microprocesseur peut encore fonctionner.

4. Procédé selon la revendication 2 ou 3, **caractérisé en ce que** la tenson de la pile, actuellement présente, est comparée aux tensions de référence et que l'un des états suivants est associé à l'état de la pile, sur la base de cette comparaison:
| | |
|---|---|
| Pile en ordre de marche | Etat B0 |
| Réserve de la pile 10 % lorsque la pile est sollicitée | Etat B1 |
| Réserve de la pile 10 % lorsque la pile n'est pas sollicitée | Etat B2 |
| Réserve de la pile 0 % lorsque la pile est sollicitée par la soupape d'amenée d'eau | Etat B3 |
| Tension minimale du microprocesseur | Etat B4 |

5. Procédé selon la revendication 4, **caractérisé en ce qu'**il est prévu un dispositif d'affichage, par exemple une diode LED, qui indique les états 1 à 4 indiqué plus haut, par exemple au moyen d'un clignotement ou d'un éclairement permanent.

6. Procédé selon la revendication 1 à 5, **caractérisé en ce que** la capacité résiduelle de la pile est tirée de sa courbe caractéristique de décharge, de l'allure décroissante de la tension de la pile en fonction du temps de décharge, et une capacité résiduelle de par exemple 10 % de la décharge complète est associée à une tension résiduelle prédéterminée de la pile.

7. Procédé selon l'une des revendications 1 à 6, **caractérisé en ce qu'**après utilisation de la pile on vérifie si la tension de la pile, non sollicitée par la soupape d'amenée d'eau, est supérieure ou inférieure à une première tension de référence U(1), et que, de façon correspondante, l'initialisation est déclenchée ou est refusée.

8. Procédé selon l'une des revendications 3 à 7, **caractérisé en ce qu'**à certains intervalles de temps comparativement brefs, par exemple toutes les secondes, la tension de la pile à l'état non sollicité par la soupape d'amenée d'eau est mesurée et que dans le cas où la tension de la pile est supérieure à U1, l'état B0 est positionné alors que, sinon, l'état B2 est positionné.

9. Procédé selon la revendication 8, **caractérisé en ce que**, lors de chaque ouverture de soupape, la tension de la pile à l'état sollicité par la soupape d'amenée d'eau est mesurée et que dans le cas où la tension de la pile est supérieure à U(1), l'état B0 est positionné et, sinon, l'état B1 est positionné.

10. Procédé selon l'une des revendications 4 à 9, **caractérisé en ce qu'**un changement de pile est indiqué par exemple au moyen d'une diode LED clignotante, lorsque l'état B1 est détecté et que la tension de la pile à l'état non sollicité par la soupape d'amenée d'eau correspond, par rapport à la tension minimale requise d'activation de la soupape, à une réserve de la pile qui est inférieure à une réserve prédéterminée de la pile, par exemple 10 %.

11. Procédé selon l'une des revendications 4 à 10, **caractérisé en ce que** la tension de la pile à l'état non sollicité par la soupape d'amenée d'eau, est mesurée en permanence à des intervalles de temps déterminés et qu'une commutation sur l'état B2 s'effectue lorsque cette tension de la pile est encore U(1).

12. Procédé selon l'une des revendications 4 à 11, **caractérisé en ce que**, dans l'état B3, l'activation de la soupape d'amenée d'eau est bloquée, que cet état est indiqué avec une lumière permanente, par exemple au moyen d'une diode LED et que, lors de chaque nouvelle impulsion de fermeture appliquée à la soupape d'amenée d'eau, une vérification est faite pour savoir si la tension déjà sollicitée de la pile ne suffit pas encore pour l'arrêt de la soupape d'amenée d'eau.

13. Procédé selon l'une des revendications 3 à 12, **caractérisé en ce que** le microprocesseur est débranché lorsque la tension de la pile est inférieure à U(P).
